# EUROPEAN PATENT SPECIFICATION

(11) **EP 0 498 663 B1**
(45) Date of publication and mention of the grant of the patent: **13.12.1995**
(21) Application number: 92301042.5
(22) Date of filing: 07.02.1992
(51) Int. Cl.: C23C 14/34, H01L 21/285

(54) **Method for producing a semi conductor device using sputtering**
Verfahren zur Herstellung einer Halbleitervorrichtung durch Sputtern
Méthode de fabrication d'un dispositif semi-conducteur à l'aide de pulvérisation

(30) Priority: 08.02.1991 JP 18007/91; 08.01.1992 JP 1741/92
(43) Date of publication of application: 12.08.1992
(73) Proprietor: SHARP KABUSHIKI KAISHA, Osaka 545 (JP)
(72) Inventor: Shimada, Yasunori, Nara-shi, Nara-ken (JP); Morimoto, Hiroshi, Kitakatsuragi-gun, Nara-ken (JP)
(74) Representative: Brown, Kenneth Richard

(56) References cited:
- PATENT ABSTRACTS OF JAPAN vol. 4, no. 166 (C-031)18 November 1980
- JOURNAL OF VACUUM SCIENCE AND TECHNOLOGY: PART A. vol. 7, no. 3, May 1989, NEWYORK US pages 1025 - 1029; ROSSNAGEL: 'Energetic particle bombardment of filmsduring magnetron sputtering' page 1027, section III A: Cathode and Gas Species
- WORLD PATENTS INDEX LATEST Week 0992, Derwent Publications Ltd., London, GB; AN92-069621

## Description

### BACKGROUND OF THE INVENTION

### 1. Field of the Invention:

The present invention relates generally to a method for producing a semiconductor device and particularly to a method for forming an electrode or an electrode wiring of the device by forming a tantalum thin film by sputtering.

### 2. Description of the Prior Art:

In the past, in a liquid crystal display device, a display pattern is formed on a screen by selecting display picture elements arranged in a matrix. As a method for selecting display picture elements, there is an active matrix driving method. According to this method, independent picture element electrodes are arranged so as to correspond to the respective picture elements, and switching elements are connected to the respective picture element electrodes, thereby performing a display. A liquid crystal display device using this method enables a display with a high contrast and can be put into practical use for TV, etc.

Examples of the switching elements for selectively driving picture element electrodes include TFT (thin film transistor) elements, MIM (metal-insulator -metal) elements, MOS (metal oxide semiconductor) transistor elements, diodes, and varistors. A voltage signal applied between the picture element electrodes and the electrodes facing thereto is switched (ON or OFF), whereby an optical modulation of liquid crystal existing therebetween is visualized as a display pattern.

In order to provide the liquid crystal display device of an active matrix driving system mentioned above with high precision, it is necessary to make the picture element electrodes as small as possible. In order to make the screen larger, for example, in the case where the switching elements are TFTs, it is necessary to make gate electrode wirings and source electrode wirings thinner and longer. Moreover, in the case where the TFT has inverted staggered structure, since the gate electrode wiring is formed in an initial stage of the process for forming the TFT, it is required that the wiring be thin and have a sufficiently low-resistance. Also, it is required that a material having a strong corrosion resistance be used for the wiring so as to withstand the subsequent process. In the past, as a material which satisfies these requirements, a metal material such as tantalum (Ta), chromium (Cr), or titanium (Ti) has been used. In particular, tantalum is mainly used, since tantalum has a strong acid resistance and a fine self-oxidized film can be obtained by an anodic oxidation method when tantalum is used as the material.

When a metallic thin film made of tantalum is formed by sputtering, argon is used as a sputtering gas in the conventional method, so that a tantalum structure becomes β-Ta and its specific resistance is in the range of 170 »Ω·cm to 200 »Ω·cm. As a conventional well-known method for decreasing this specific resistance, there is a method for doping argon with nitrogen (see, for example Patent Abstracts of Japan vol. 4 no. 166 (C-031), 18^{th} November 1980 & JP-A-55 107 774). It is confirmed that according to this method, the specific resistance can be minimized in the range of 70 »Ω·cm to 100 »Ω·cm.

However, the specific resistance at this level is not sufficient. When the gate electrode wiring is made longer and thinner in a liquid crystal display device using the tantalum film as the electrode wiring for the purpose of realizing a large screen and high precision, the electrical resistance of the gate electrode wiring rapidly rises and the time constant of the gate electrode wiring increases. When the time constant of the gate electrode wiring increases, a rising of an ON signal at the TFT disposed at the end of the gate electrode wiring becomes slow. Also, a falling of the ON signal from ON to OFF becomes slow. Because of this, the picture element at the end of the gate electrode wiring is not sufficiently charged during the writing of its signal, and the picture element takes in signals of the other picture elements. As a result, the liquid crystal display device cannot perform a normal display.

Accordingly, in order for the liquid crystal display device to perform a normal display, it is necessary to decrease the electrical resistance of the gate electrode wiring. As a means for this, a gate electrode wiring with a two-layered or three-layered structure using a material which can be readily formed into a thin film having a low specific resistance such as aluminium and molybdenum is considered.

However, in this kind of gate electrode wiring with a multi-layered structure, the process for manufacturing becomes complicated because of the necessity of an increase in the processes for forming films and the photolithography processes. In addition, the above-mentioned materials have a lower acid resistance compared with tantalum, so that the gate electrode wiring is likely to be damaged in the process after forming the TFT and a disconnection occurs, resulting in decreased reliability and yield.

In Japanese Laid-Open Patent Publication No. 62-205656, a method for decreasing the specific resistance of a thin film which is a material for the gate electrode wiring by mixing molybdenum with tantalum is proposed. According to this method, the specific resistance of a thin film becomes 40 »Ω·cm.

However, when an alloy is formed by mixing molybdenum with tantalum, molybdenum contained in the film is eluted in the process for anodizing the gate electrode wiring, and an oxide film whose molecular orientation is denser than that of an oxide film obtained by anodizing tantalum cannot be obtained.

### SUMMARY OF THE INVENTION

This invention provides a method for producing a semiconductor device comprising forming an electrode or an electrode wiring by forming a tantalum thin film by sputtering, wherein a krypton gas in which nitrogen is mixed as a reactive gas is used as a sputtering gas, and a product of the pressure of the sputtering gas and a target-substrate distance is set in the range of 0.01 m·Pa to 0.08 m·Pa.

In a preferred embodiment, an input electrical power density applied to the target is set at 3.0 W/cm² or more.

In a preferred embodiment, the pressure of the sputtering gas is set in the range of 2.0 x 10⁻¹ Pa to 7.0 x 10⁻¹ Pa when the target-substrate distance is 80 mm.

In a preferred embodiment, the pressure of the sputtering gas is set at 4.0 x 10⁻¹ Pa.

In a preferred embodiment, the pressure of the sputtering gas is set in the range of 0.7 x 10⁻¹ Pa to 4.0 x 10⁻¹ Pa when the target-substrate distance is in the range of 150 mm to 200 mm.

In a preferred embodiment, the pressure of the sputtering gas is set in the range of 2.0 x 10⁻¹ Pa to 7.0 x 10⁻¹ Pa when the target-substrate distance is 65 mm.

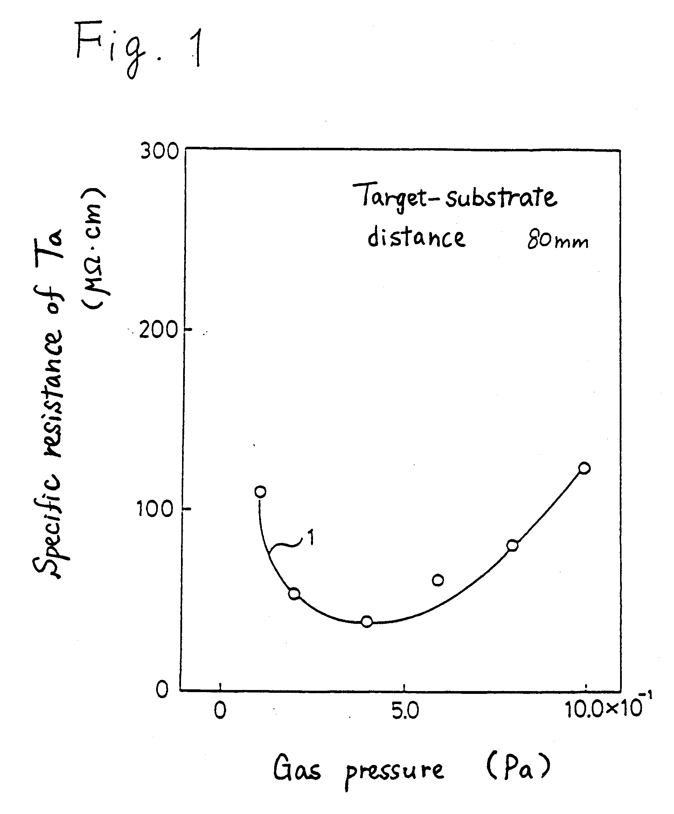

As is apparent from graphs shown in Figures **1**, **3**, and **4** when the sputtering gas in which nitrogen is mixed as a reactive gas is used under the conditions described above, a tantalum film having a remarkably lower specific resistance compared with the prior art can be formed.

Thus, the invention described herein makes possible the objective of providing a method for producing a semiconductor device in which a thin film of tantalum having a sufficiently low specific resistance and a high acid resistance can be formed in a simple process, whereby a semiconductor device whose reliability and yield are improved can be produced at a low cost.

### BRIEF DESCRIPTION OF THE DRAWINGS

Figure **1** is a graph showing a relationship between the specific resistance of a tantalum thin film and the gas pressure of a sputtering gas in the case when the target-substrate distance is 80 mm.

Figure **2** is a graph showing a relationship between the specific resistance of the tantalum thin film and the input electric power density with respect to the target.

Figure **3** is a graph showing a relationship between the specific resistance of a tantalum thin film and the gas pressure of a sputtering gas in the case when the target-substrate distance is 150 mm to 200 mm.

Figure **4** is a graph showing a relationship between the specific resistance of the tantalum thin film and the gas pressure of the sputtering gas in the case when the target-substrate distance is 65 mm.

### DESCRIPTION OF THE PREFERRED EMBODIMENTS

Hereinafter, the present invention will be described by way of illustrative examples.

### Example 1

In the present example, as a sputtering device, a well-known magnetron sputtering device of a DC plane parallel plate type was used. A substrate made of the following material was set in a chamber of the sputtering device, and the sputtering was performed under the conditions described below, thereby forming a tantalum thin film on the surface of the substrate as an electrode or an electrode wiring.

As the substrate, a substrate which was subjected to a predetermined treatment for forming a TFT on the surface thereof, such as a glass substrate made of quartz, silica having a concentration of 96% to 98%, or borosilicate; a BaO-Al₂O₃-B₂O₃-SiO₂ glass substrate manufactured by Corning Incorporated. 7059 (Trade No.); an Si wafer substrate; or a substrate obtained by coating an oxide insulation film of Ta₂O₅ or SiO₂ on the respective surfaces of the above-mentioned substrates was used.

After the above-mentioned substrate was set in the chamber of the sputtering device, the chamber was suctioned to be evacuated so that the internal pressure of the chamber became 1.0 x 10⁻⁴ Pa or less. Then, a krypton gas in which nitrogen was mixed was introduced into the chamber which was depressurized as described above, and the internal pressure was kept at a constant value in the range of 2.0 x 10⁻¹ Pa to 7.0 x 10⁻¹ Pa. Moreover, the target-substrate distance was maintained at 80 mm. At this time, the product of the gas pressure and the target-substrate distance became 0.016 m·Pa to 0.056 m·Pa.

Under the above-mentioned conditions, the pre-sputtering was performed at an electrical power (an input electrical power density applied to the target of the sputtering device) of 1.0 W/cm² or more, and then the input electrical power was set to a value of 3.0 W/cm² or more. The sputtering was performed for the purpose of forming a tantalum thin film by using, as a sputtering gas, the krypton gas in which nitrogen was mixed as a reactive gas. When a tantalum thin film having a desired thickness was formed by this sputtering, the electrical power supply was stopped. At the same time, the introduction of the sputtering gas into the chamber was stopped. The substrate was cooled for a predetermined period of time, after which it was taken out of the chamber. Thus, the substrate on which the tantalum thin film was formed was obtained. After that, the substrate was subjected to the treatments for forming a TFT, if required, whereby a semiconductor device (e.g., a liquid crystal display device) using a tantalum thin film as an electrode or an electrode wiring was produced.

Figure **1** is a graph showing the relationship between the specific resistance (»Ω·cm) of the tantalum thin film formed as described above and the pressure of the sputtering gas (Pa), in the case that the amount of nitrogen doped was 7.4%.

As is apparent from a characteristic curve **1** in the graph, when the sputtering is performed by setting the gas pressure in the range of 0.2 Pa to 0.7 Pa, the specific resistance of the tantalum thin film becomes 60 »Ω·cm or less, and the specific resistance can be reduced compared with the prior art using argon as a sputtering gas in which the specific resistance is in the range of 70 »Ω·cm to 100 »Ω·cm. In particular, a tantalum thin film having a sufficiently low specific resistance of 40 »Ω·cm or less is realized in the vicinity of 0.4 Pa, so that the sputtering in the vicinity of this value is preferred.

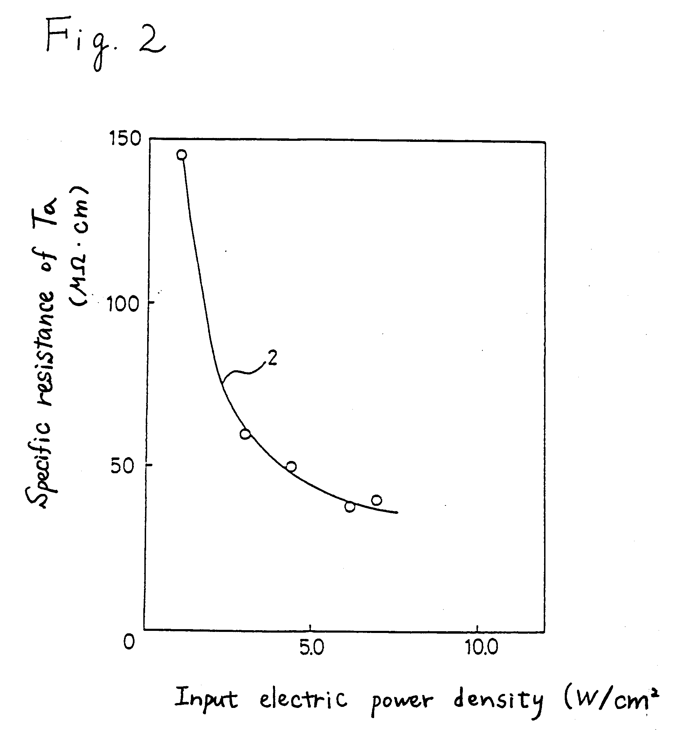

Figure **2** is a graph showing the relationship between the specific resistance of the tantalum thin film and the input electrical power density (W/cm²) with respect to the target, in the case that the amount of nitrogen doped is 7.4%.

As is apparent from a characteristic curve **2** in the graph, the specific resistance of the tantalum thin film is decreased with the increase in the input electrical power density. It is understood that the specific resistance of the tantalum thin film can be made lower than the range of 70 »Ω·cm to 100 »Ω·cm of the above-mentioned prior art at 3.0 W/cm² or more. Accordingly, the sputtering is preferably performed at an input electrical power density of 3.0 W/cm² or more.

### Example 2

The substrate described in Example 1 was set in the chamber of the sputtering device, and then the chamber was suctioned to be evacuated so that the internal pressure of the chamber became 1.0 x 10⁻⁴ Pa or less. Then, a krypton gas in which nitrogen was mixed was introduced into the chamber which was depressurised as described above, and the internal pressure was kept at a constant value in the range of 0.7 x 10⁻¹ Pa to 4.0 x 10⁻¹ Pa. Moreover, the target-substrate distance was maintained in the range of 150 mm to 200 mm. At this time, the product of the gas pressure and the target-substrate distance became 0.0105 m·Pa to 0.08 m·Pa.

Under the above-mentioned conditions, the pre-sputtering was performed at an electrical power (an input electrical power density applied to the target of the sputtering device) of 1.0 W/cm² or more, and then the input electrical power was set to a value of 3.0 W/cm² or more. The sputtering was performed for the purpose of forming a tantalum thin film by using, as a sputtering gas, krypton gas in which nitrogen was mixed as a reactive gas. When a tantalum thin film having a desired thickness was formed by this sputtering, the supply of the electrical power was stopped. At the same time, the introduction of the sputtering gas into the chamber was stopped. The substrate was cooled for a predetermined period of time, after which it was taken out of the chamber. Thus, the substrate on which the tantalum thin film was formed was obtained. After that, the substrate was subjected to the treatments for forming a TFT, if required, whereby a semiconductor device (e.g., a liquid crystal display device) using a tantalum thin film as an electrode or an electrode wiring was produced.

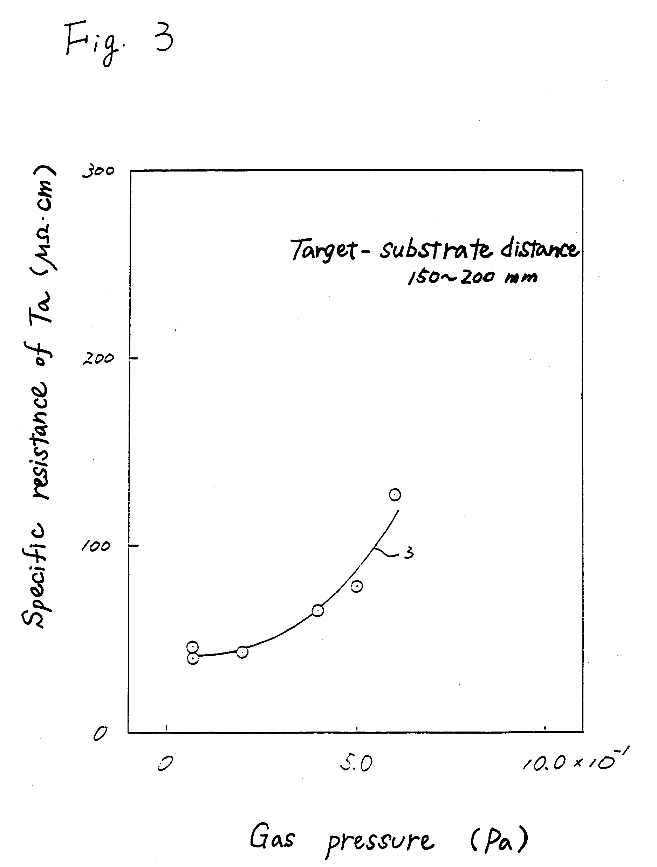

Figure **3** is a graph showing the relationship between the specific resistance (»Ω·cm) of the tantalum thin film formed as described above and the pressure of the sputtering gas (Pa), in the case that the amount of nitrogen doped is 6.8%.

As is apparent from a characteristic curve **3** in the graph, when the sputtering is performed by setting the gas pressure in the range of 0.7 x 10⁻¹ Pa to 4.0 x 10⁻¹ Pa, the specific resistance of the tantalum thin film becomes 60 »Ω·cm or less.

### Example 3

The substrate described in Example 1 was set in the chamber of the sputtering device, the chamber was suctioned to be evacuated so that the internal pressure of the chamber became 1.0 x 10⁻⁴ Pa or less. Then, a krypton gas in which nitrogen was mixed was introduced into the chamber which was depressurized as described above, and the internal pressure was kept at a constant value in the range of 2.0 x 10⁻¹ Pa to 7.0 x 10⁻¹ Pa. Moreover, the target-substrate distance was maintained at 65 mm. At this time, the product of the gas pressure and the target-substrate distance became 0.013 m·Pa to 0.046 m·Pa.

Under the above-mentioned conditions, the pre-sputtering was performed at an electrical power (an input electrical power density applied to the target of the sputtering device) of 1.0 W/cm² or more, and then the input electrical power was set to a value of 3.0 W/cm² or more. The sputtering was performed for the purpose of forming a tantalum thin film by using, as a sputtering gas, the krypton gas in which nitrogen was mixed as a reactive gas. When a tantalum thin film having a desired thickness was formed by this sputtering, the electrical power supply was stopped. At the same time, the introduction of the sputtering gas into the chamber was stopped and cooled for a predetermined period of time, after which the substrate was taken out of the chamber. Thus, the substrate on which the tantalum thin film was formed was obtained. After that, the substrate was subjected to the treatments for forming a TFT, if required, whereby a semiconductor device (e.g., a liquid crystal display device) using a tantalum thin film as an electrode or an electrode wiring was produced.

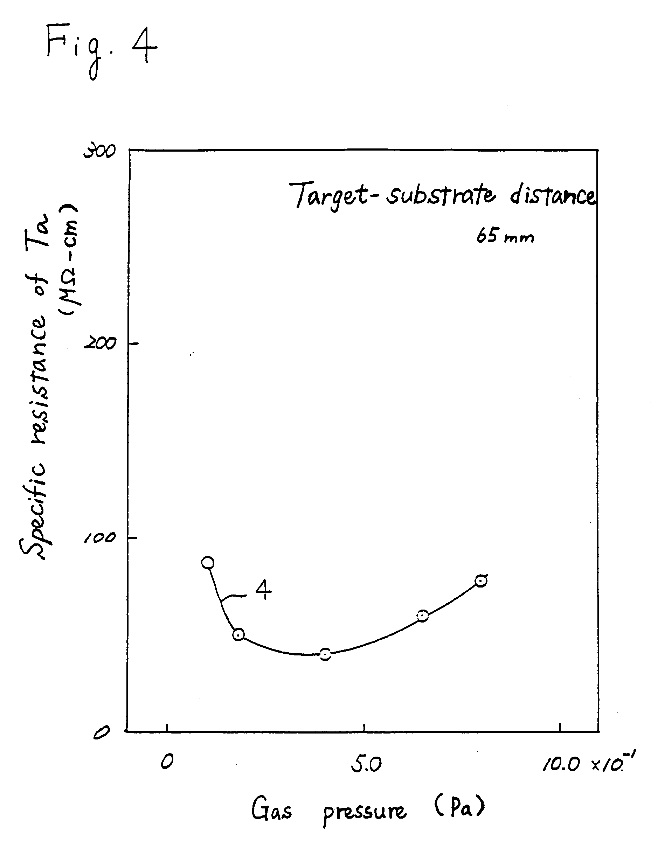

Figure **4** is a graph showing the relationship between the specific resistance (»Ω·cm) of the tantalum thin film formed as described above and the pressure of the sputtering gas (Pa), in the case that the amount of nitrogen doped is 3.8%.

As is apparent from a characteristic curve **4** in the graph, when the sputtering is performed by setting the gas pressure in the range of 2.0 x 10⁻¹ Pa to 7.0 x 10⁻¹ Pa, the specific resistance of the tantalum thin film becomes 60 »Ω·cm or less.

As described above, according to the present invention, a tantalum thin film having a specific resistance which is about one half of that of the prior art can be formed. Accordingly, an electrical resistance of a gate electrode wiring and the like can be made lower without using a multi-layered structure, so that when this kind of the tantalum thin film is applied to a liquid crystal display device, the liquid crystal display device with high precision and a large screen can be readily obtained. Moreover, there is an advantage that a high yield can be maintained without increasing the number of processes for forming films or photolithography processes. In addition, the increase in the production cost caused by the increase in the processes can be prevented. Furthermore, the tantalum thin film has a high acid resistance, so that the reliability can be improved without generating a disconnection during the subsequent steps. An oxide film having a dense molecular orientation can be obtained by the anodic oxidation method, so that the leak defects can be avoided in a similar way as in the prior art.

## Claims

1. A method for producing a semiconductor device comprising forming an electrode or an electrode wiring by forming a tantalum thin film by sputtering, wherein a krypton gas in which nitrogen is mixed as a reactive gas is used as a sputtering gas, and a product of the pressure of the sputtering gas and a target-substrate distance is set in the range of 0.01 m·Pa to 0.08 m·Pa.

2. A method for producing a semiconductor device according to claim 1, wherein an input electrical power density applied to the target is set at 3.0 W/cm² or more.

3. A method for producing a semiconductor device according to claim 1, wherein the pressure of the sputtering gas is set in the range of 2.0 x 10⁻¹ Pa to 7.0 x 10⁻¹ Pa when the target-substrate distance is 80 mm.

4. A method for producing a semiconductor device according to claim 3, wherein the pressure of the sputtering gas is set at 4.0 x 10⁻¹ Pa.

5. A method for producing a semiconductor device according to claim 1, wherein the pressure of the sputtering gas is set in the range of 0.7 x 10⁻¹ Pa to 4.0 x 10⁻¹ Pa when the target-substrate distance is in the range of 150 mm to 200 mm.

6. A method for producing a semiconductor device according to claim 1, wherein the pressure of the sputtering gas is set in the range of 2.0 x 10⁻¹ Pa to 7.0 x 10⁻¹ Pa when the target-substrate distance is 65 mm.

7. A method for producing a semiconductor device according to claim 1, wherein said sputtering gas includes nitrogen gas in the range of 3.8 vol% to 7.4 vol% with respect to said krypton gas.

## Patentansprüche

1. Verfahren zum Herstellen eines Halbleiter-Bauteils, bei dem eine Elektrode oder eine Elektrodenverdrahtung durch Herstellen eines Tantal-Dünnfilms durch Sputtern ausgebildet wird, wobei Kryptongas, in das Stickstoff als Reaktionsgas eingemischt ist, als Sputtergas verwendet wird und das Produkt aus dem Druck des Sputtergases und dem Target-Substrat-Abstand im Bereich von 0,01 m · Pa bis 0,08 m · Pa eingestellt wird.

2. Verfahren zum Herstellen eines Halbleiter-Bauteils nach Anspruch 1, bei dem die elektrische Eingangsleistungsdichte am Substrat auf 3,0 W/cm² oder mehr eingestellt wird.

3. Verfahren zum Herstellen eines Halbleiter-Bauteils nach Anspruch 1, bei dem der Druck des Sputtergases im Bereich von 2,0 x 10⁻¹ Pa bis 7,0 x 10⁻¹ Pa eingestellt wird, wenn der Target-Substrat-Abstand 80 mm beträgt.

4. Verfahren zum Herstellen eines Halbleiter-Bauteils nach Anspruch 3, bei dem der Druck des Sputtergases auf 4,0 x 10⁻¹ Pa eingestellt wird.

5. Verfahren zum Herstellen eines Halbleiter-Bauteils nach Anspruch 1, bei dem der Druck des Sputtergases im Bereich von 0,7 x 10⁻¹ Pa bis 4,0 x 10⁻¹ Pa eingestellt wird, wenn der Target-Substrat-Abstand im Bereich von 150 mm bis 200 mm liegt.

6. Verfahren zum Herstellen eines Halbleiter-Bauteils nach Anspruch 1, bei dem der Druck des Sputtergases im Bereich von 2,0 x 10⁻¹ Pa bis 7,0 x 10⁻¹ Pa eingestellt wird, wenn der Target-Substrat-Abstand 65 mm beträgt.

7. Verfahren zum Herstellen eines Halbleiter-Bauteils nach Anspruch 1, bei dem das Sputtergas Stickstoffgas im Bereich von 3,8 Vol.-% bis 7,4 Vol.-% bezogen auf das Kryptongas enthält.

## Revendications

1. Procédé de production d'un dispositif semi-conducteur comportant la formation d'une électrode ou d'un câblage d'électrode par formation d'un film mince de tantale par pulvérisation, dans lequel un gaz krypton dans lequel de l'azote est mélangé comme gaz réactif est utilisé comme gaz de pulvérisation, et un produit de la pression du gaz de pulvérisation et d'une distance cible-support est réglé dans la plage de 0,01 m.Pa à 0,08 m.Pa.

2. Procédé de production d'un dispositif semi-conducteur selon la revendication 1, dans lequel une densité de puissance électrique d'entrée appliquée sur la cible est réglée à 3,0 W/cm² ou davantage.

3. Procédé de production d'un dispositif semi-conducteur selon la revendication 1, dans lequel la pression du gaz de pulvérisation est réglée dans la plage de 2,0 x 10⁻¹ Pa à 7,0 x 10⁻¹ Pa lorsque la distance cible-support est de 80 mm.

4. Procédé de production d'un dispositif semi-conducteur selon la revendication 3, dans lequel la pression du gaz de pulvérisation est réglée à 4,0 x 10⁻¹ Pa.

5. Procédé de production d'un dispositif semi-conducteur selon la revendication 1, dans lequel la pression du gaz de pulvérisation est réglée dans la plage de 0,7 x 10⁻¹ Pa à 4,0 x 10⁻¹ Pa lorsque la distance cible-support est dans la plage de 150 mm à 200 mm.

6. Procédé de production d'un dispositif semi-conducteur selon la revendication 1, dans lequel la pression du gaz de pulvérisation est réglée dans la plage de 2,0 x 10⁻¹ Pa à 7,0 x 10⁻¹ Pa lorsque la distance cible-support est de 65 mm.

7. Procédé de production d'un dispositif semi-conducteur selon la revendication 1, dans lequel ledit gaz de pulvérisation comprend de l'azote gazeux dans la plage de 3,8% en volume à 7,4% en volume par rapport audit gaz krypton.
